Europäisches Patentamt

European Patent Office

Office européen des brevets

(19)

(11) Veröffentlichungsnummer: **0 280 979 B1**

(12) **EUROPÄISCHE PATENTSCHRIFT**

(45) Veröffentlichungstag der Patentschrift: **03.06.92**

(51) Int. Cl.⁵: **G03F 7/027**, G03F 7/004

(21) Anmeldenummer: **88102527.4**

(22) Anmeldetag: **20.02.88**

(54) **Lichtempfindliches Aufzeichnungsmaterial mit erhöhter Flexibilität.**

(30) Priorität: **28.02.87 DE 3706561**

(43) Veröffentlichungstag der Anmeldung:
**07.09.88 Patentblatt 88/36**

(45) Bekanntmachung des Hinweises auf die
Patenterteilung:
**03.06.92 Patentblatt 92/23**

(84) Benannte Vertragsstaaten:
**BE CH DE FR GB IT LI NL**

(56) Entgegenhaltungen:
**EP-A- 0 209 803**

(73) Patentinhaber: **BASF Aktiengesellschaft
Carl-Bosch-Strasse 38
W-6700 Ludwigshafen(DE)**

(72) Erfinder: **Koch, Horst, Dr.
Tiefenthaler Strasse 47
W-6718 Gruenstadt(DE)**
Erfinder: **Schupp, Hans, Dr.
Jean-Voelker-Strasse 40
W-6520 Worms 1(DE)**
Erfinder: **Schwalm, Reinhold, Dr.
Am Huettenwingert 53
W-6706 Wachenheim(DE)**

## Beschreibung

Die Erfindung betrifft ein lichtempfindliches Aufzeichnungsmaterial mit einer auf einem Träger aufgebrachten, ein polymeres Bindemittel enthaltenden, fotopolymerisierbaren Aufzeichnungsschicht, welches insbesondere für die Herstellung von Druckformen oder Resistmustern geeignet ist. Insbesondere betrifft die Erfindung eine Aufzeichnungsschicht, die ein Produkt ergibt, welches als flexibler fotopolymerisierbarer Film brauchbar ist.

Die bekannten, mit wäßrig-alkalischen oder organischen Entwicklerlösungen auswaschbaren, lichtempfindlichen Aufzeichnungselemente für die Herstellung von fotopolymeren Druckformen oder Resistmustern enthalten auf einem dimensionsstabilen Träger, z.B. einer Kunststoff-Folie oder einem Metallblech, eine fotopolymerisierbare Aufzeichnungsschicht, im allgemeinen aus einer Mischung von mindestens einem in den wäßrig-alkalischen oder organischen Entwicklerlösungen löslichen oder dispergierbaren polymeren Bindemittel, mindestens einer ethylenisch ungesättigten, fotopolymerisierbaren, niedermolekularen Verbindung, mindestens einem Photoinitiator sowie gegebenenfalls weiteren, die verarbeitungs- und/oder anwendungstechnischen Eigenschaften verbessernden und/oder modifizierenden Zusatz- und/oder Hilfsstoffen.

Als polymere Bindemittel für die wäßrig-alkalisch entwickelbaren fotopolymerisierbaren Aufzeichnungsschichten gelangen hierbei insbesondere in den wäßrig-alkalischen Entwicklerlösungen lösliche oder zumindest dispergierbare, carboxylgruppenhaltige oder Carbonsäureanhydrid-Gruppen enthaltende Copolymerisate zur Anwendung, wie z.B. Styrol/Maleinsäureanhydrid-Copolymerisate, Styrol/Maleinsäurehalbester-Copolymerisate, Alkyl-(meth)acrylat/(Meth)acrylsäure-Copolymerisate oder auch Copolymerisate aus Styrol, Alkyl(meth)-acrylaten und (Meth)acrylsäure sowie gegebenenfalls weiteren Comonomeren (vgl. u.a. DE-B-20 27 467, SU-PS 190 211, DE-A-22 05 146, EP-A-49 504 oder DE-A-27 36 058).

Bindemittel, die in organisch entwickelbaren fotopolymerisierbaren Aufzeichnungsschichten eingesetzt werden, bestehen überwiegend aus Polymeren oder Copolymeren von Styrol und/oder (Meth)-acrylathaltigen Monomeren. Solche Copolymere sind z.B. in US-PS 3 469 982, DE-A-3 215 513 oder DE-A-3 131 448 beschrieben.

Schichten aus diesen Bindemitteln sind zwar in wäßrig-alkalischen bzw. organischen Entwicklerlösungen löslich oder dispergierbar, zeigen aber in belichtetem, d.h. vernetztem Zustand eine hohe Sprödigkeit und eine geringe Haftung zu den Basismaterialien. Ein spröder Film kann während der Verwendung brechen. Wird eine solche Schicht etwa als Ätz- oder Galvanoresist bei der Herstellung von gedruckten Schaltungen verwendet, so können die Ätz- oder Galvaniklösungen an den Stellen, an denen der Resist gebrochen ist, eindringen und die darunterliegende Metallschicht so angreifen, daß die gesamte Schaltung unbrauchbar wird. Die Gefahr des Brechens ist dabei besonders bei flexiblen Leiterplatten gegeben, die als Trägermaterial nur einen dünnen, beweglichen Kunststofffilm haben. Besonders nachteilig ist die Sprödigkeit auch bei der Verwendung als Lötstoppmaske. Diese wird vor dem Löten auf die Leiterplatte aufgebracht und soll die darunterliegenden Leiterbahnen vor dem 250°C heißen Lötlack schützen. Ferner muß die Lötstoppmaske stabil gegen Lösemittel und Chemikalien sein und sehr gute elektrische Eigenschaften wie hohen Durchgangswiderstand, Durchschlagfestigkeit und niedrige Dielektrizitätskonstante haben, da sie im allgemeinen auf der Schaltung verbleibt und als permanente Schutz- und Isolationsschicht dient. Bei der Verwendung von Trockenfilmresisten als Lötstoppmaske ist eine hohe Sprödigkeit besonders störend, da durch auftretende Risse Feuchtigkeit etc. eindringen kann und die Schaltung korrodieren läßt oder zu Kriechströmen führt. Beim Schneiden einer mit einer Lötstoppfolie beschichteten Leiterplatte kommt es an den Kanten überdies immer wieder zu Absplitterungen, so daß Teile des darunterliegenden Kupfers freigelegt werden. Ein brüchiger Film kann daher nicht auf Anwendungsgebieten für flexible Schaltungen verwendet werden, sein Einsatz als Lötstoppfolie würde schwerwiegende Nachteile mit sich bringen.

Nach dem Stand der Technik werden äußere Weichmacher in das fotopolymerisierbare Material eingearbeitet, um die schlechte Flexibilität zu überwinden. Dies ist jedoch nicht völlig zufriedenstellend, da solche Weichmacher dazu neigen, bei der Alterung in dem Film zu wandern und stark zum Kaltfließen beitragen. Kaltfließen kann nicht toleriert werden, da die Filmrollen unter statischer Belastung gelagert werden und das fotopolymerisierbare Material nach kurzer Zeit beginnt, zwischen den Schichten herauszusickern. Danach verschmilzt das Material entlang der Kante der Rollen und macht es schwierig, wenn nicht sogar unmöglich, das Material gleichmäßig und ohne Zerstörung des zusammengesetzten Filmes abzurollen. Außerdem sind viele Weichmacher flüchtig. Während der Herstellung des Filmes verdampft etwas von dem Weichmacher, wenn das Trocknen nicht genau kontrolliert wird, wobei der Film in seinen brüchigen Zustand zurückgeführt wird.

In der US-Patentschrift 3,036,914 wird eine fotopolymerisierbare Masse mit erhöhter Flexibilität beschrieben, die aus einer ethylenisch ungesättigten Verbindung, wie Diacrylaten oder (Meth)-acrylsäureestern von Polyalkylenglykolen, einem Fotoinitiator, einem hochmolekularen Polyethylenoxid und mindestens einem linearen Celluloseester besteht.

In den US-Patentschriften 3,887,450 und 3,953,309 wird eine fotopolymerisierbare Masse beschrieben, die in wäßrig-alkalischer Lösung entwickelt werden kann und als flexibler Film auf einer Rolle stabil ist. Diese Schicht besteht aus einem fotopolymerisierbaren ethylenisch ungesättigten Monomer, einem Fotoinitiator, einem Polymerisationsinhibitor und einem Bindemittel, das aus einem oder mehreren Styrol- oder Vinylmonomeren und einem oder mehreren $\alpha,\beta$-ethylenisch ungesättigten Säure- oder Anhydrid-Monomeren zusammengesetzt ist. Ein weiterer Fortschritt wird in der US-Patentschrift 4,239,849 angegeben: Es wird eine flexible, gegen den kalten Fluß beständige Schicht beschrieben, die auf einer Rolle stabil ist und wäßrig-alkalisch entwickelt werden kann. Diese Masse besteht aus einem oder mehreren Monomeren, einem Fotoinitiator und einem polymeren Bindemittel, das ein Copolymer aus einem Styrol-Monomer, einem Acrylmonomer und einem ungesättigten carboxylgruppenhaltigen Monomer ist.

Eine Schicht mit erhöhter Flexibilität wird auch in der EP-A-128 014 beschrieben, Dabei besteht die fotopolymerisierbare Masse aus einem oder mehreren (Meth)acrylsäureestern, einem Fotoinitiator, einem Polymerisationsinhibitor und einem Bindemittel aus einem Styrol-Monomeren, einem Acrylmonomeren und einem ungesättigten Säure- oder Anhydridgruppen enthaltenden Monomeren. Auch in der DE-A-2 602 410 wird eine solche Schicht beschrieben.

Alle diese Schichten sind zwar im unbelichteten Zustand auf der Rolle stabil und flexibel, zeigen nach der Belichtung aber immer noch eine hohe Sprödigkeit und verringerte Haftung zum Basissubstrat. Erhöht man insbesondere die Vernetzungsdichte soweit, daß die Schicht die für eine Lötstoppmaske notwendige Temperatur- und Chemikalienresistenz zeigt, so ist in jedem Fall das Material so empfindlich, daß es beim Biegen der Schaltung bricht und Teile davon von dem Basismaterial abplatzen.

In der EP-A 0 209 803 wird ein Flüssigstrahldruckkopf beschrieben, zu dessen Herstellung ein lichtempfindliches Aufzeichnungsmaterial mit einer auf einem dimensionsstabilen Träger aufgebrachten photopolymerisierbaren Aufzeichnungsschicht eingesetzt wird, die eine niedermolekulare ethylenisch ungesättigte photopolymerisierbare organische Verbindung, einen Photoinitiator sowie ein polymeres Bindemittel enthält. Dieses Bindemittel kann zwar durch radikalische Copolymerisation eines Makromeren und einer olefinisch ungesättigten organischen Verbindung hergestellt werden, jedoch werden hier Pfropfcopolymere mit einer starren Hauptkette mit einer Glastemperatur > 50°C empfohlen, damit das lichtempfindliche Gemisch in Form eines Films verwendet werden kann.

Aufgabe der vorliegenden Erfindung war es, fotopolymerisierbare Schichten zu entwickeln, die im unbelichteten Zustand auf einer Rolle aufgewickelt stabil sind und nicht zum kalten Fluß neigen, im belichteten und vernetzten Zustand aber noch ausreichend flexibel sind, gute Haftung zu den Basismaterialien zeigen und bei mechanischer Deformation nicht brechen.

Es wurde nun überraschenderweise gefunden, daß diese Aufgabe durch lichtempfindliche Aufzeichnungslemente mit einer auf einem dimensionsstabilen Träger aufgebrachten, wäßrig-alkalisch oder organisch entwickelbaren fotopolymerisierbaren Aufzeichnungsschicht gelöst wird, wenn die fotopolymerisierbare Aufzeichnungsschicht als polymeres Bindemittel mindestens ein filmbildendes Copolymerisat enthält, das z.B. in Form eines Kammpolymeren aus geeigneten (Meth)acrylat-Monomeren und/oder Styrol-Monomeren sowie weiteren Monomeren so aufgebaut ist, daß es eine mehrphasige Morphologie aufweist.

Gegenstand der Erfindung ist ein lichtempfindliches, zur Herstellung von Druckformen oder Resistmustern geeignetes Aufzeichnungsmaterial mit einer auf einem dimensionsstabilen Träger aufgebrachten, wäßrig-alkalisch oder mit organischen Lösungsmitteln entwickelbaren photopolymerisierbaren Aufzeichnungsschicht, die ein in wäßrig-alkalischen Medien oder in organischen Lösungsmitteln lösliches oder dispergierbares polymeres Bindemittel, mindestens eine niedermolekulare ethylenisch ungesättigte photopolymerisierbare organische Verbindung, mindestens einen Photopolymerisationsinitiator sowie gegebenenfalls weitere Zusatz- und/oder Hilfsstoffe enthält, das dadurch gekennzeichnet ist, daß als polymeres Bindemittel mindestens ein filmbildendes Copolymerisat eingesetzt wird, das eine mehrphasige Morphologie aufweist, wobei mindestens eine Phase eine Glastemperatur unterhalb Raumtemperatur und mindestens eine weitere Phase eine Glastemperatur oberhalb Raumtemperatur aufweist und dieses Copolymerisat durch radikalische Copolymerisation von mindestens einem Makromeren mit mindestens einer weiteren olefinisch ungesättigten copolymerisierbaren organischen Verbindung erhalten wurde, und wobei in dem als polymeres Bindemittel eingesetzten Copolymerisat mit mehrphasiger Morphologie die kontinuierliche Phase eine Glastemperatur unterhalb Raumtemperatur und die dispergierte Phase eine Glastemperatur oberhalb Raumtemperatur aufweist.

Bevorzugt ist, daß das polymere Bindemittel aus einem filmbildenden Copolymerisat besteht, das eine zweiphasige Morphologie und ein mittleres Molekulargewicht (Gewichtsmittel) von über 10.000 aufweist. Bevorzugt ist außerdem, zur Herstellung des als polymeres Bindemittel verwendeten Copolymerisats ein Makromeres mit einem mittleren Molekulargewicht (Gewichtsmittel] von 1000 bis 100 000 einzusetzen.

Durch den erfindungsgemäßen Einsatz der speziellen Copolymerisate als polymeres Bindemittel in den fotopolymerisierbaren Aufzeichnungsschichten werden lichtempfindliche Aufzeichnungselemente mit vorteilhaften, teilweise überraschend verbesserten Eigenschaften erhalten. So zeigen die lichtempfindlichen Aufzeichnungselemente bei der Lagerung auf einer Rolle keine Neigung zum kalten Fluß und sind nach der Belichtung mit aktinischem Licht noch so flexibel, daß sie sich als Resist für dünne, flexible Schaltungen eignen. Insbesondere zeigen die erfindungsgemäßen Aufzeichnungsmaterialien nach der vollständigen Aushärtung, wie sie für eine Lötstoppmaske nötig ist, eine gute Haftung zum Basissubstrat und eine hohe Flexibilität.

Zu den Aufbaukomponenten der erfindungsgemäßen Aufzeichnungsmaterialien ist im einzelnen folgendes auszuführen.

Bei den erfindungsgemäß in der fotopolymerisierbaren Aufzeichnungsschicht der lichtempfindlichen Aufzeichnungslemente enthaltenen polymeren Bindemittel handelt es sich um spezielle Copolymerisate, die in wäßrig-alkalischen bzw. organischen Lösungsmitteln löslich oder zumindest dispergierbar sind. Die erfindungsgemäß einzusetzenden Copolymerisate sollen filmbildend sein und haben im allgemeinen ein mittleres Molekulargewicht (Gewichtsmittel) größer als 10.000, vorzugsweise im Bereich von etwa 15.000 bis etwa 500.000 und insbesondere im Bereich von etwa 20.000 bis 250.000.

Die erfindungsgemäß einzusetzenden Copolymerisate sind aufgebaut aus mehreren Comonomeren, wobei z.B. mindestens ein Monomer eine Verbindung mit einem Molekulargewicht von 1.000 bis 100.000, vorzugsweise 3.000 - 20.000, ist und nur eine polymerisierbare Gruppe besitzt. Solche makromolekularen Monomere werden im allgemeinen auch als Makromere bezeichnet und sind schon seit längerer Zeit aus der Literatur bekannt. Verwiesen sei hier z.B. auf die Übersichtsartikel von P. Rempp, Plaste Kautschuk 28, 365 (1981), G.O. Schulz, R. Milkovich, J. Appl. Polym. Sci. 27, 4773 (1982), J.P. Kennedy, Rubber Chem. Technol. 56, 639 (1983) und P. Rempp, E. Franta, Advances in Polymer Science Vol. 58, S. 1 (1984).

Auch mehrphasige Copolymere mit diesen makromolekularen Monomeren sind bereits beschrieben worden, z.B. in G.O. Schulz, R. Milkovich, J. Polym. Sci., Polym. Chem. Ed. 22, 1633 (1984) und im US-Patent 3,786,116.

Erfindungsgemäß und insbesondere für den Einsatz in Resisten werden Art und Menge der Comonomeren so gewählt, daß die kontinuierliche Phase des mehrphasigen Copolymeren eine Glastemperatur unterhalb der Raumtemperatur besitzt und die dispergierte Phase eine Glastemperatur oberhalb der Raumtemperatur besitzt. Dabei wird bevorzugt die kontinuierliche Phase eine niedrige vorzugsweise unterhalb 10°C und die dispergierte Phase eine hohe Glastemperatur vorzugsweise oberhalb 40°C haben. Der Anteil des makromolekularen Monomers (= Makromeren) liegt im allgemeinen im Bereich von 5 Gew.-% bis 70 Gew.-%, vorzugsweise von 10 bis 40 Gew.-% der Gesamtmenge der zur Herstellung des Copolymerisats eingesetzten Momomeren.

Als Makromere eignen sich übliche kurzkettige Polymere mit einer polymerisierbaren Doppelbindung am Kettenende. Beispiele für Makromere, die sich für den Einsatz in polymeren Bindemitteln als besonders vorteilhaft erwiesen haben, sind Polystyrolmonoacrylate bzw. Polystyrolmonomethacrylate mit Molekulargewichten zwischen 3.000 und 20.000, Copolymere aus Styrol und Methacrylsäure, die endständig eine (Meth)acrylgruppe tragen, und Copolymere aus Methylmethacrylat und (Meth)acrylsäure, die endständig eine vinylisch ungesättigte Gruppe besitzen, sowie Poly-(2,6-dimethyl)phenylenoxid-mono(meth)acrylate.

Die erfindungsgemäß als polymeres Bindemittel einzusetzenden filmbildenden Copolymerisate können nach den an sich bekannten und üblichen Polymerisationsmethoden durch radikalische Copolymerisation der Makromeren mit anderen Comonomeren, beispielsweise in Lösung, hergestellt werden.

Als Comonomere, die mit den Makromeren copolymerisiert werden, eignen sich die üblichen copolymerisierbaren ethylenisch ungesättigten organischen Verbindungen, insbesondere niedermolekulare ethylenisch ungesättigte Verbindungen, wie Vinylaromaten, z.B. Styrol, substituierte Styrole, die in der Seitenkette oder im Kern beispielsweise durch Alkylgruppen oder Halogenatome substituiert sind, wie α-Methylstyrol und p-Methylstyrol, die Ester der Acrylsäure und Methacrylsäure mit $C_1$-$C_8$-Monoalkoholen, insbesondere die Acrylate und Methacrylate von geradkettigen oder verzweigten Mono- oder Dialkoholen, vorzugsweise mit 1 bis 4 C-Atomen; Acrylsäure, Methacrylsäure; Vinylester von Carbonsäuren mit 2 bis 8 C-Atomen, wie z.B. Vinylacetat, Vinylpropionat; Acrylnitril, Methacrylnitril, Ester der Malein- und/oder Fumarsäure oder auch Gemische dieser Verbindungen.

Bevorzugte Comonomere zur Herstellung der erfindungsgemäßen polymeren Bindemittel sind Styrol, Methacrylsäure, Acrylsäure, Hydroxyalkyl-(meth)acrylate, Methylmethacrylat und Butylmethacrylat.

Die Auswahl der Comonomeren und deren Menge im Vergleich zum Makromer richtet sich nach den gewünschten Eigenschaften, wie Glastemperatur und Löslichkeit im Entwicklungsmedium.

Für den Fall der Entwicklung im wäßrig-alkalischen Medium ist es nötig, daß das polymere Bindemittel etwa 5 bis 40 Gew.% carboxylgruppenhaltige Comonomere wie Acrylsäure, Methacrylsäure, Maleinsäure, Fumarsäure oder Halbester der letztgenannten Dicarbonsäuren enthält. Zusätzlich ist es zweckmäßig, weitere hydrophile Comonomere wie Hydroxyalkyl(meth)acrylate oder (Meth)acrylnitril einzupolymerisieren. Die Menge und das Verhältnis der dabei eingesetzten Comonomere richtet sich dabei nach den Anforderungen wie schnelles und vollständiges Auswaschen in einer alkalischen Lösung, aber möglichst hohe Beständigkeit gegenüber sauren und neutralen Bädern.

Für die Entwickelbarkeit in organischen Lösungsmitteln, wie chlorierten Kohlenwasserstoffen, ist es zweckmäßig, als Comonomere überwiegend hydrophobe Verbindungen wie Styrol, Ester der Acrylsäure oder Methacrylsäure mit 1 bis 8 C-Atomen oder Vinylester der Carbonsäuren einzusetzen.

Für die Lösungspolymerisation eignen sich als Lösungsmittel beispielsweise niedere Alkohole, wie z.B. Methanol, Ethanol, Propanol, Ketone, wie z.B. Aceton oder Butanon, Ester, wie z.B. Essigsäureethylester, und ähnliche Lösungsmittel sowie Gemische derartiger Lösungsmittel.

Als Polymerisationsinitiatoren kommen die üblichen radikalischen Starter, wie beispielsweise Azobis-isobutyronitril, Benzoylperoxid und dgl., in Betracht. Die Polymerisationstemperatur liegt im allgemeinen zwischen 50° C und 100° C.

In der photopolymerisierbaren Aufzeichnungsschicht der erfindungsgemäßen lichtempfindlichen Aufzeichnungselemente können ein oder mehrere Copolymerisate der in Rede stehenden Art als polymeres Bindemittel enthalten sein. Neben dem polymeren Bindemittel enthält die photopolymerisierbare Aufzeichnungsschicht im allgemeinen noch mindestens eine ethylenisch ungesättigte, photopolymerisierbare, niedermolekulare Verbindung, mindestens einen Photopolymerisationsinitiator bzw. ein Photopolymerisationsinitiatorsystem sowie gegebenenfalls weitere Zusatz- und/oder Hilfsstoffe zur Verbesserung bzw. Modifizierung der allgemeinen Eigenschaften der lichtempfindlichen Aufzeichnungselemente bzw. der hieraus hergestellten Druckformen oder Resistmuster.

Als ethylenisch ungesättigte, photopolymerisierbare niedermolekulare Verbindungen kommen sowohl Monomere als auch ethylenisch ungesättigte, photopolymerisierbare Oligomere mit einem Molekulargewicht bis etwa 5.000 in Betracht, wobei die photopolymerisierbaren niedermolekularen Verbindungen sowohl mono- als auch mehrfunktionell sein können, d.h. eine oder mehrere photopolymerisierbare, ethylenische Doppelbindungen besitzen können. Üblicherweise sind in der photopolymerisierbaren Aufzeichnungsschicht di- oder mehrfunktionelle ethylenisch ungesättigte, photopolymerisierbare niedermolekulare Verbindungen allein oder Mischungen hiervon mit einem untergeordneten Anteil an monofunktionellen ethylenisch ungesättigten, photopolymerisierbaren niedermolekularen Verbindungen enthalten. Als Vertreter für die ethylenisch ungesättigten, photopolymerisierbaren, niedermolekularen Verbindungen, die in der photopolymerisierbaren Aufzeichnungsschicht allein oder auch in Mischung miteinander enthalten sein können, seien insbesondere die Derivate der Acrylsäure und Methacrylsäure und hier vor allem die (Meth)acrylsäureester genannt. Beispiele hierfür sind die Di- und Tri-(meth)acrylate von Di- oder Polyolen wie Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiole, Glycerin oder Pentaerythrit; Pentaerythrittetra-(meth)acrylat, Glukosetri- oder -tetra(meth)acrylat; ferner die Monoacrylate und Monomethacrylate der genannten Diole und Polyole, wie z.B. Ethylenglykol-, Di-, Tri- oder Tetraethylenglykol-mono(meth)acrylat, Propandiol-mono(meth)acrylat und Butandiolmono-(meth)acrylat, und die (Meth)acrylate von Monoalkanolen, insbesondere solche von Monoalkanolen mit 1 bis 20 C-Atomen. Ferner sind als ethylenisch ungesättigte, photopolymerisierbare niedermolekulare Verbindungen die monomeren und oligomeren Urethanacrylate und -methacrylate mit zwei oder mehr Acryloyl- und oder Methacryloyl-Gruppen im Molekül zu nennen. Solche monomeren oder oligomeren Urethan-(meth)acrylate, die gegebenenfalls neben den Acryloyl- und/oder Methacryloyl-Gruppen auch noch freie Carboxylgruppen enthalten können, sind nach üblichen und an sich bekannten Verfahren erhältlich, beispielsweise durch Umsetzung von Diolen oder Polyolen der vorstehend genannten Art mit Di- oder Polyisocyanaten, beispielsweise Hexamethylendiisocyanat, Isophorondiisocyanat oder ähnlichen, unter Bildung eines Reaktionsprodukts mit freien Isocyanatgruppen und Umsetzung dieser Isocyanatgruppen mit beispielsweise Hydroxyalkyl(meth)acrylaten. Man kann auch zunächst die Hydroxyalkyl-(meth)acrylate mit den Di- oder Polyisocyanaten umsetzen und das resultierende ungesättigte Isocyanat anschließend mit der Diol- oder Polyolkomponente zur Reaktion bringen. Zur Einführung von freien Carboxyl-Gruppen in die Urethan-Verbindungen kann ein Teil der Hydroxylgruppen der Diol- bzw. vorzugsweise Polyol-Komponente mit mehrfachen Carbonsäuren bzw. insbesondere cyclischen Dicarbonsäureanhydriden unter Bildung der sauren Teilester der Carbonsäuren umgesetzt werden. Geeignete ethylenisch ungesättigte, photopolymerisierbare niedermolekulare Verbindungen für die erfindungsgemäßen lichtempfindlichen Aufzeichnungselemente sind auch die Acryloyl- und/oder Methacryloyl-Gruppen enthaltenden Verbindungen, wie sie erhalten werden durch Umsetzung von Acrylsäure und/oder Methacrylsäure mit Di- oder Polyepoxid-Verbindungen.

Neben den bevorzugt verwendeten Acrylaten und Methacrylaten, insbesondere der vorstehend genannten Art, seien als ethylenisch ungesättigte, photopolymerisierbare niedermolekulare Verbindungen auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und des N-Methylol-(meth)acrylamids, Vinylcarbamate, Bisacrylamidoessigsäure und andere.

Die ethylenisch ungesättigten, photopolymerisierbaren niedermolekularen Verbindungen werden dabei - für den Fachmann selbstverständlich - so gewählt, daß sie mit den als polymeren Bindemitteln eingesetzten Copolymerisaten verträglich sind. Das Mengenverhältnis von polymerem Bindemittel zu den ethylenisch ungesättigten, photopolymerisierbaren niedermolekularen Verbindungen in der photopolymerisierbaren Aufzeichnungsschicht kann in weiten Grenzen, beispielsweise im Bereich von 10:90 bis 90:10 variiert werden und liegt im allgemeinen insbesondere im Bereich von 40:60 bis 90:10. Der Anteil der polymeren Bindemittel und ethylenisch ungesättigten, photopolymerisierbaren niedermolekularen Verbindungen in der photopolymerisierbaren Aufzeichnungsschicht richtet sich neben der Art dieser Verbindungen, insbesondere nach dem gewünschten Eigenschaftsbild der lichtempfindlichen Aufzeichnungselemente bzw. der hieraus hergestellten Druckformen oder Resistmuster. Im allgemeinen wird dieses Verhältnis so gewählt, daß die photopolymerisierbare Aufzeichnungsschicht bei Raumtemperatur fest ist. Dies gilt insbesondere für den Einsatz der erfindungsgemäßen lichtempfindlichen Aufzeichnungsmaterialien als Photoresistfilm. Im übrigen sind die Kriterien für die Auswahl des Verhältnisses von polymerem Bindemittel zu ethylenisch ungesättigter, photopolymerisierbarer niedermolekularer Verbindung in Abhängigkeit von der Art dieser Verbindungen dem Fachmann geläufig.

Als Photopolymerisationsinitiatoren für die photopolymerisierbaren Aufzeichnungsschichten kommen die für lichtempfindliche, photopolymerisierbare Aufzeichnungsmaterialien üblichen und an sich bekannten Photoinitiatoren bzw. Photoinitiator-Systeme in Betracht. Beispielhaft seien hier genannt: Benzoin, Benzoinether, insbesondere Benzoinalkylether, substituierte Benzoine, Alkylether von substituierten Benzoinen, wie beispielsweise α-Methylbenzoinalkylether oder α-Hydroxymethylbenzoinalkylether; Benzile, Benzilketale, insbesondere Benzildimethylketal, Benzilmethylethylketal oder Benzilmethylbenzylketal; die als Photoinitiator wirksamen Acylphosphinoxid-Verbindungen, wie z.B. substituierte Benzoyl-diarylphosphinoxide; Benzophenon, Derivate des Benzophenons, 4,4'-Dimethylaminobenzophenon, 4,4'-Diethylaminobenzophenon, Derivate von Michlers Keton; Anthrachinon und substituierte Anthrachinone; arylsubstituierte Imidazole oder deren Derivate, wie z.B. 2,4,5-Triarylimidazoldimere; 2-Chlorthioxanthon und die als Photoinitiatoren wirksamen Acridin- oder Phenacinderivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michlers Keton, oder Gemische aus 2,4,5-Triarylimidazoldimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiator-Systeme sind in der photopolymerisierbaren Aufzeichnungsschicht im allgemeinen in Mengen von 0,001 bis 10 Gew.-%, insbesondere in Mengen von 0,05 bis 5 Gew.-%, bezogen auf die photopolymerisierbare Aufzeichnungsschicht, enthalten.

Als weitere Zusatz- und/oder Hilfsstoffe, die in der photopolymerisierbaren Aufzeichnungsschicht der erfindungsgemäßen lichtempfindlichen Aufzeichnungselemente enthalten sein können, kommen z.B. thermische Polymerisationsinhibitoren, Farbstoffe und/oder Pigmente, photochrome Verbindungen bzw. Systeme, sensitometrische Regler, Weichmacher, Verlaufshilfsmittel, Füllstoffe, Verstärkungsmittel, Mattierungs- oder Gleitmittel und dgl. in Betracht. Geeignete thermische Polymerisationsinhibitoren sind z.B. Hydrochinon, Hydrochinon-Derivate, 2,6-Di-t.-butyl-p-kresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind unter anderem Brilliant Green Dye (C.I. 42 040), Victoria Reinblau FGA, Victoria Reinblau BO (C.I. 42 595), Malachitgrün, Kristallviolett, Victoria-Blau B (C.I. 44 045), Rodamin-6 (C.I. 45 160), Naphthalimidfarb-

stoffe, Azosole und 3'-Phenyl-7-dimethylamino-2,2'-spirodi-(2H-1-benzopyran). Photochrome Systeme, die bei Belichtung mit aktinischem Licht ihre Farbe reversibel oder irreversibel ändern, ohne hierbei den Photopolymerisationsprozeß zu stören, sind z.B. Leuko-Farbstoffe zusammen mit geeigneten Aktivatoren. Als Beispiele für Leuko-Farbstoffe seien die Leuko-Basen der Triphenylmethanfarbstoffe, wie Kristallviolett-Leukobase und Malachitgrün-Leukobase, Leuko-Basisch-Blau, Leuko-Pararosanilin, Leuko-Patentblau A und V genannt; ferner kommt auch Rhodamin B-Base in Betracht. Als Aktivatoren für diese photochromen Verbindungen kommen unter anderem organische Halogenverbindungen, die bei Bestrahlung mit aktinischem Licht Halogenradikale abspalten, oder Hexaarylbisimidazole in Betracht. Zu den sensitometrischen Reglern gehören Verbindungen wie z.B. 9-Nitroanthracen, 10,10'-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Zusatzstoffe üblichen und bekannten wirksamen Mengen vorhanden. Ihre Menge sollte jedoch im allgemeinen 30 Gew.-%, vorzugsweise 20 Gew.-%, bezogen auf die photopolymerisierbare Aufzeichnungsschicht, nicht überschreiten.

Das Mischungsverhältnis, in dem die einzelnen Komponenten in der photopolymerisierbaren Aufzeichnungsschicht vorhanden sind, wird im allgemeinen so gewählt, daß die Aufzeichnungsschicht nicht nur organisch oder wäßrig-alkalisch entwickelbar, sondern vorteilhafterweise auch bei Raumtemperatur fest ist und gute Filmbildungseigenschaften besitzt. Für die Verwendung als Photoresistfilm wird die Zusammensetzung darüber hinaus so gewählt, daß die photopolymerisierbare Aufzeichnungsschicht gut laminierbar und unter Anwendung von Druck sowie gegebenenfalls Wärme auf ein Substrat übertragbar ist. Die Dicke der photopolymerisierbaren Aufzeichnungsschicht richtet sich bekanntermaßen nach dem Anwendungszweck der lichtempfindlichen Aufzeichnungselemente und kann dementsprechend in weiten Grenzen schwanken. Während sie für die Herstellung von Resistmustern im allgemeinen im Bereich von etwa 1 bis 50 $\mu$m liegt, kommen für die Herstellung von Hochdruckformen beispielsweise Schichtdicken von etwa 100 $\mu$m bis einigen mm in Betracht.

In einer typischen Ausführungsform der Erfindung besteht die photopolymerisierbare Aufzeichnungsschicht der lichtempfindlichen Aufzeichnungselemente beispielsweise aus einer homogenen, filmbildenden und in wäßrig-alkalischen Entwicklerlösungen löslichen oder zumindest dispergierbaren Mischung von

a) 40 bis 90 Gew.-% mindestens eines filmbildenden Copolymerisats, das eine mehrphasige Morphologie aufweist, der vorstehend genannten Art als polymerem Bindemittel,

b) 8 bis 55 Gew.-% mindestens einer ethylenisch ungesättigten, photopolymerisierbaren niedermolekularen Verbindung mit 2 oder mehr polymerisierbaren Doppelbindungen oder Mischungen hiervon mit einem untergeordneten Anteil an ethylenisch ungesättigten, photopolymerisierbaren, niedermolekularen Verbindungen mit nur einer photopolymerisierbaren Doppelbindung, wobei die ethylenisch ungesättigten, photopolymerisierbaren niedermolekularen Verbindungen mit dem polymeren Bindemittel verträglich sein sollen,

c) 0,001 bis 10 Gew.-% mindestens eines Photopolymerisationsinitiators bzw. eines Photopolymerisationsinitiator-Systems sowie

d) 0 bis 30 Gew.-%, insbesondere 0,05 bis 20 Gew.-%, an weiteren, die allgemeinen Eigenschaften der lichtempfindlichen Aufzeichnungselemente bzw. der hieraus hergestellten Druckformen oder Resistmuster verbessernden bzw. modifizierenden Zusatz- und/oder Hilfsstoffen.

Als Träger für die photopolymerisierbaren Aufzeichnungsschichten kommen die für lichtempfindliche Aufzeichnungselemente der in Rede stehenden Art an sich bekannten und üblichen, dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder -Folien, z.B. Polyesterfolien, sowie metallische Schichtträger, beispielsweise Stahl- oder Aluminiumbleche, in Betracht. Für Photoresistfilme und Schichtübertragungsmaterialien finden als Trägermaterialien vorzugsweise Kunststoff-Filme oder -Folien, z.B. Polyesterfolien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - wahlweise vor oder nach der bildmäßigen Belichtung mit aktinischem Licht - abgezogen werden können. Für die Herstellung von Resistmustern kann die photopolymerisierbare Aufzeichnungsschicht auch direkt auf das zu schützende sowie gegebenenfalls dauerhaft zu modifizierende Substrat aufgebracht werden, welches dann als Schichtträger für die photopolymerisierbare Aufzeichnungsschicht dient. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelemente, Silicium-Wafer und dgl. in Betracht. Die Trägermaterialien für die photopolymerisierbare Aufzeichnungsschicht können gegebenenfalls in an sich bekannter Weise z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein, die bei lichtempfindlichen Aufzeichnungselementen für die Herstellung von Druckformen beispielsweise als Haftschichten und/oder Lichthofschutzschichten ausgebildet sein können.

Ebenso kann auf der dem Träger abgewandten Oberfläche der photopolymerisierbaren Aufzeichnungsschicht auch noch eine Deckschicht oder Deckfolie angeordnet sein, die vorzugsweise in der gleichen Entwicklerlösung löslich ist, wie die photopolymerisierbare Aufzeichnungsschicht, oder von dieser vor der Entwicklung abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungsmaterialien und auch als Sauerstoffsperre für die photopolymerisierbare Aufzeichnungsschicht. Als besonders geeignet haben sich beispielsweise Deckschichten aus Polyvinylalkoholen oder Polyvinylalkohol-Derivaten bzw., insbesondere für Photoresistfilme, Deckfolien aus Polyolefinen, z.B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen -dimensionsstabilen Träger erfolgen. Vorteilhafterweise werden die lichtempfindlichen Aufzeichnungselemente hergestellt, indem man die Komponenten der photopolymerisierbaren Aufzeichnungsschicht in einem geeigneten Lösungsmittel bzw. Lösungsmittel-Gemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon.

Anschließend kann auf die photopolymerisierbare Aufzeichnungsschicht gewünschtenfalls noch die Deckschicht bzw. Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impuls-Lampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein. Durch die bildmäßige Belichtung mit dem aktinischen Licht wird in den belichteten Bereichen der Aufzeichnungsschicht eine Photopolymerisation ausgelöst, die zu einer Vernetzung und damit Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung bzw. mit einem organischen Lösungsmittel(gemisch) entwickelt. Das Entwickeln kann durch Waschen, Sprühen, Abreiben oder Ausbürsten etc. erfolgen. Die erfindungsgemäßen Aufzeichnungselemente zeigen dabei einen großen Entwicklungsspielraum und eine sehr geringe Überwaschempfindlichkeit. Als wäßrig-alkalische Entwicklerlösungen kommen die üblichen in Betracht, die zur Einstellung des günstigsten pH-Wertes, im allgemeinen im Bereich von 8 bis 14, vorzugsweise im Bereich von 9 bis 12, alkalisch reagierende Substanzen, wie z.B. Borax, Dinatriumhydrogenphosphat, Soda, Alkalihydroxide oder organische Basen, wie Di- oder Triethanolamin, in Wasser gelöst enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dgl., mitverwendet werden. Die wäßrig-alkalischen Entwicklerlösungen können auch noch geringe Zusätze von wasserlöslichen, organischen Lösungsmitteln, wie z.B. aliphatischen Alkoholen enthalten.

Für den Fall der Entwicklung mit organischem Lösungsmittel oder Lösungsmittelgemischen kommen vorzugsweise gesättigte Chlorkohlenwasserstoffe, wie Trichlorethan, in Frage.

Die erfindungsgemäßen lichtempfindlichen Aufzeichnungselemente zeichnen sich durch ihre guten Belichtungseigenschaften und gute Entwickelbarkeit aus, wodurch es möglich ist, auch sehr feine Bildelemente vorlagengetreu und sicher zu reproduzieren. Auf metallischen oder metalloxidischen Untergründen besitzen die erfindungsgemäßen photopolymerisierbaren Aufzeichnungsschichten eine sehr gute Haftung, ohne daß es bei der Entwicklung der bildmäßig belichteten Aufzeichnungsschicht zur Ausbildung von Restschichtbelägen in den ausgewaschenen Bereichen kommt. Die erfindungsgemäßen lichtempfindlichen Aufzeichnungselemente eignen sich grundsätzlich für alle Anwendungsgebiete der Reprographie und der optischen Informationsfixierung, insbesondere zur Herstellung von Druckformen, Resistmustern sowie infolge ihrer hohen Flexibilität und guten Haftung auf dem Basissubstrat zur Herstellung von Lötstoppmasken.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

In ein mit Rührer, Rückflußkühler und Stickstoffeinleitungsrohr versehenes Reaktionsgefäß werden nacheinander folgende Komponenten zugegeben:
20 Teile Acrylsäure
50 Teile n-Butylacrylat
30 Teile eines Polystyrolmonoacrylats mit einem Molekulargewicht von 4.500
200 Teile Methylethylketon
1 Teil Azo-bis-isobutyronitril (= AIBN).

Die Mischung wird 20 Minuten unter Stickstoffspülung bei Raumtemperatur gelöst und anschließend 8 Stunden unter Rückfluß gekocht. Nach dem Abkühlen wird die Lösung in n-Hexan ausgefällt und der Niederschlag im Vakuumtrockenschrank getrocknet. Man erhält ein Polymer, das aus Lösung zu einem transparenten elastischen und klebfreien Film vergießbar ist. Das Polymer zeigt zwei Glastemperaturen von +30°C und +64°C.

Beispiel 2

In ein wie für Beispiel 1 ausgestattetes Reaktionsgefäß werden eingewogen:
20 Teile Acrylsäure
20 Teile Hydroxypropylacrylat
40 Teile Tetraethylenglykolmonoacrylat
20 Teile eines Polystyrolmonoacrylats mit einem Molekulargewicht von 4.500
150 Teile Methylethylketon.

Die Lösung wird auf 80°C erhitzt und mit 0,5 Teilen AIBN versetzt. Nach 8 Stunden Reaktionszeit wird der Inhalt aus Petrolether ausgefällt. Eine Probe dieses Polymeren läßt sich als klebfreier, elastischer, transparenter Film gießen. Das Polymer zeigt zwei Glastemperaturen von -9°C und +55°C.

Beispiel 3

Analog Beispiel 1 stellt man ein Polymer aus einem Gemisch aus
30 Teilen n-Butylacrylat,
30 Teilen Hydroxypropylacrylat,
20 Teilen Acrylsäure,
20 Teilen Polystyrolmonoacrylat mit einem Molekulargewicht von 4.500 in
150 Teilen Methylethylketon
her.

Das Polymer bildet aus Lösung einen transparenten, elastischen, klebfreien Film. Die Glastemperaturen liegen bei -15°C und +49°C.

Beispiel 4

Wie in Beispiel 1 beschrieben, wird ein Polymer aus
40 Teilen n-Butylacrylat,
23 Teilen Hydroxypropylacrylat,
20 Teilen Acrylsäure und
20 Teilen eines Copolymeren aus 84 % Styrol und 16 % Methacrylsäure mit einer endständigen Acrylatgruppe und einem Molekulargewicht von ca. 5.000 in
150 Teilen Methylethylketon
hergestellt.
Man erhält ein Polymer, das aus Lösung zu einem transparenten, elastischen und klebfreien Film vergießbar ist.

Beispiel 5

Wie in Beispiel 1 beschrieben, wurde aus
70 Teilen n-Lauryl-Acrylat und
30 Teilen eines Polystyrolmonoacrylates mit einem Molekulargewicht von 13.000
ein Polymer hergestellt, das zwei Glastemperaturen (-64°C/+54°C) zeigt und aus Lösung einen klebfreien, transparenten, elastischen Film bildet.

Beispiel 6

Ein polymeres Bindemittel wird hergestellt aus:
32 Teilen Poly-2,6-Dimethylphenylenoxid-monoacrylat mit einem Molekulargewicht von 7.500
30 Teilen Hydroxypropylacrylat
38 Teilen n-Butylacrylat.
Das Polymere ist transparent, filmbildend und elastisch.

Beispiel 7

Wie in Beispiel 1 beschrieben, wurde aus
16 Teilen Poly-2,6-Dimethylphenylenoxid-monoacrylat mit einem Molekulargewicht von ca. 15.000
29 Teilen Hydroxypropylacrylat und
55 Teilen n-Butylacrylat
ein polymeres Bindemittel hergestellt.
Als Glastemperaturen wurden -40°C und +90°C ermittelt.

Vergleichsbeispiel 1

Es wird wie in Beispiel 1 verfahren, statt des Makromeren aber Styrol eingesetzt. Man erhält ein sprödes, hartes, nicht elastisches Polymer mit einer einzigen Glastemperatur von 53°C.

Beispiel 8

Das polymere Bindemittel wurde analog Beispiel 1 aus
20 Teilen Acrylsäure,
60 Teilen n-Butylacrylat und
20 Teilen eines Polystyrolmonoacrylats mit einem Molekulargewicht von 4.500
hergestellt.
Das erhaltene Polymer zeigt zwei Glastemperaturen (+12°C/62°C) und läßt sich als transparenter elastischer Film gießen.

Vergleichsbeispiel 2

Es wird wie in Beispiel 8 verfahren, aber statt des Makromeren Styrol eingesetzt. Man erhält ein Polymer mit einer einzigen Glastemperatur von +27°C. Ein aus Lösung gegossener Film ist klebrig und zeigt starken plastischen Fluß.

Beispiel 9

Analog Beispiel 1 wird ein polymeres Bindemittel aus
25,6 Teilen n-Butylacrylat,
2,8 Teilen Acrylsäure,
39,6 Teilen Methylpolyglykolacrylat und
32 Teilen eines Polystyrolmonoacrylats mit einem Molekulargewicht von 13.000

hergestellt.
Das erhaltene Polymer zeigt zwei Glastemperaturen (8°C/85°C) und bildet einen transparenten, elastischen Gießfilm.

Beispiel 10

Eine Lösung aus
60 Teilen des Bindemittels aus Beispiel 2,
16,8 Teilen Hexandioldiacrylat,
20 Teilen verkapptes Isophorondiisocyanat,
3 Teilen Benzophenon und
0,07 Teilen Michlers Keton in
150 Teilen Methylethylketon
wird mit Hilfe eines Laborgießers auf eine Polyethylenterephthalatfolie gegossen und bei 80°C in einem Umlufttrockenschrank getrocknet, so daß eine Schichtdicke von 75 μm entsteht. Man erhält eine elastische, transparente Schicht, die mit einem handelsüblichen Laminator auf eine gedruckte Schaltung aufgebracht werden kann. Diese Schicht wird durch ein Negativ belichtet und die unbelichteten Teile werden mit einer 1%igen Natriumcarbonatlösung ausgewaschen. Die Schaltung wird anschließend bei 150°C 1 Stunde lang ausgehärtet. Es resultiert ein Film mit ausgezeichneter Haftung und guter Flexibilität.

Beispiel 11

Es wird eine Lösung aus
66,6 Teilen des Bindemittels aus Beispiel 3,
30 Teilen eines Umsetzungsproduktes aus Butandioldiglycidylether mit Methacrylsäure,
3,4 Teilen Benzophenon und
0,13 Teilen Michlers Keton
hergestellt.
Man gießt wie in Beispiel 10 eine Folie mit einer Trockenschichtdicke von 35 μm. Diese transparente, elastische Folie wird auf ein flexibles Trägermaterial aus einer kupferkaschierten Polyimidfolie auflaminiert und durch ein Negativ belichtet. Nach dem Entwickeln in 1%iger Natriumcarbonatlösung erhält man ein Schaltungsbild der Schicht, das auch durch Biegen des Substrates nicht bricht oder abplatzt. Danach kann das Kupfer in einer handelsüblichen Ätzlösung weggeätzt werden. Die Resistschicht wird anschließend in 3%iger Kaliumhydroxidlösung bei 50°C entschichtet.

Beispiel 12

Es wird, wie in Beispiel 10 beschrieben, eine Folie aus einem Gemisch aus
76,6 Teilen des Bindemittels aus Beispiel 4,
20,0 Teilen Trimethylolpropantriacrylat,
3,4 Teilen Benzophenon und
0,13 Teilen Michlers Keton

hergestellt.

Man erhält eine klebfreie, elastische, transparente Schicht. Nach Belichten durch ein Negativ können die unbelichteten Teile mit Trichlorethan entwickelt werden und das Schaltungsbild in einem handelsüblichen Galvanikbad mit Zinn verstärkt werden. Nach Entschichten mit Methylenchlorid und Ätzen des Kupfers erhält man eine Schaltung hoher Qualität.

Beispiel 13

Eine 75 μm dicke Schicht wird aus einem Gemisch aus
56 Teilen des Bindemittels aus Beispiel 4,
21 Teilen des Umsetzungsproduktes aus Butandioldiglycidylether mit Methacrylsäure,
20 Teilen verkapptes Isophorondiisocyanat,
3 Teilen Benzophenon und
0,07 Teilen Michlers Keton
hergestellt.

Man erhält eine transparente, elastische Schicht, die wie im Beispiel 12 verarbeitet werden kann. Es resultiert eine Lötstoppmaske hoher Qualität.

Beispiel 14

In einem Brabender Plastographen wurden folgende Komponenten 30 Minuten bei 120°C geknetet:
88,5 Teile des Bindemittels aus Beispiel 9
4,87 Teile Glycidylmethacrylat
0,03 Teile Dimethylaminopyridin
0,2 Teile 2,6-Di-(tert.butyl)Kresol
5 Teile Tetraethylenglykoldimethacrylat
1 Teile Benzildimethylketal
0,4 Teile Kaliumsalz des $N^2$-Hydroxi-$N^1$-Cyclohexyl-diazeniumoxid.

Die homogene Mischung wird mittels einer hydraulischen Presse auf ein 240 μm dickes, mit einem 5 μm dicken Haftlack versehenes Stahlblech so gepreßt, daß eine Schichtdicke von 640 μm resultiert. Nach dem Aufkaschieren einer 9 μm dicken Polyesterfolie wird die Mischung 20 Minuten durch ein Negativ belichtet. Anschließend wird die Polyesterfolie entfernt und die belichtete Schicht 15 Minuten in 0,5%iger Natronlauge mit einem Bürstenwascher entwickelt. Nach der Trocknung wird ein Klischee erhalten, das den transparenten Bereichen des Negativs entspricht. Die flexible Hochdruckplatte besitzt eine klebfreie Oberfläche und liefert auch bei mehrmaligem Gebrauch sehr gute Druckergebnisse.

## Patentansprüche

1. Lichtempfindliches, zur Herstellung von Druckformen oder Resistmustern geeignetes Aufzeichnungsmaterial mit einer auf einem dimensionsstabilen Träger aufgebrachten, wäßrig-alkalisch oder mit organischen Lösungsmitteln entwickelbaren photopolymerisierbaren Aufzeichnungsschicht, die ein in wäßrig-alkalischen Medien oder in organischen Lösungsmitteln lösliches oder dispergierbares polymeres Bindemittel, mindestens eine niedermolekulare ethylenisch ungesättigte photopolymerisierbare organische Verbindung, mindestens einen Photopolymerisationsinitiator sowie gegebenenfalls weitere Zusatz- und/oder Hilfsstoffe enthält, dadurch gekennzeichnet, daß als polymeres Bindemittel mindestens ein filmbildendes Copolymerisat eingesetzt wird, das eine mehrphasige Morphologie aufweist, wobei mindestens eine Phase eine Glastemperatur unterhalb Raumtemperatur und mindestens eine weitere Phase eine Glastemperatur oberhalb Raumtemperatur aufweist und dieses Copolymerisat durch radikalische Copolymerisation von mindestens einem Makromeren mit mindestens einer weiteren olefinisch ungesättigten copolymerisierbaren organischen Verbindung erhalten wurde, und wobei in dem als polymeres Bindemittel eingesetzten Copolymerisat mit mehrphasiger Morphologie die kontinuierliche Phase eine Glastemperatur unterhalb Raumtemperatur und die dispergierte Phase eine Glastemperatur oberhalb Raumtemperatur aufweist.

2. Lichtempfindliches Aufzeichnungsmaterial nach Anspruch 1, dadurch gekennzeichnet, daß das polymere Bindemittel aus einem filmbildenden Copolymerisat besteht, das eine zweiphasige Morphologie aufweist.

3. Lichtempfindliches Aufzeichnungsmaterial nach einem der Ansprüche 1 oder 2, dadurch gekennzeichnet, daß das polymere Bindemittel ein mittleres Molekulargewicht (Gewichtsmittel) von über 10.000 aufweist.

4. Lichtempfindliches Aufzeichnungsmaterial nach einem der vorhergehenden Ansprüche, dadurch gekennzeichnet, daß das zur Herstellung des als polymeres Bindemittel eingesetzten Copolymerisats verwendete Makromeres ein mittleres Molekulargewicht (Gewichtsmittel) von 1000 bis 100 000 aufweist.

## Claims

1. A photosensitive recording material which is suitable for producing a printing plate or a resist pattern and incorporates a photopolymerizable recording layer which has been applied to a dimensionally stable base material, is developable with aqueous alkali or with organic solvents, and contains a polymeric binder which is soluble or dispersible in aqueous alkaline media or in organic solvents, one or more low molecular weight ethylenically unsaturated photopolymerizable organic compounds and one or more photopolymerization initiators with or without further additive and/or auxiliary substances, wherein the polymeric binder comprises one or more film-forming copolymers which have a multiphase morphology, with one or more phases having a glass transition temperature below room temperature and one or more further phases having a glass transition temperature above room temperature, this or these copolymers having been obtained by free radical copolymerization of one or more macromers with one or more further olefinically unsaturated copolymerizable organic compounds, and, in the multiphase morphology copolymer used as polymeric binder, the continuous phase having a glass transition temperature below room temperature and the dispersed phase having a glass transition temperature above room temperature.

2.  A photosensitive recording material as claimed in claim 1, wherein the polymeric binder comprises a film-forming copolymer which has a two-phase morphology.

3.  A photosensitive recording material as claimed in either of claims 1 and 2, wherein the polymeric binder has an average molecular weight (weight average) of over 10,000.

4.  A photosensitive recording material as claimed in any of the preceding claims, wherein the macromer used for preparing the copolymer used as polymeric binder has an average molecular weight (weight average) of from 1,000 to 100,000.

**Revendications**

1.  Matériau d'enregistrement sensible à la lumière, approprié à la confection de clichés ou modèles réserve, comportant une couche d'enregistrement photopolymérisable, développable avec des solvants aqueux-alcalins ou organiques, appliquée sur un support doué de stabilité dimensionnelle, qui contient un liant polymère, soluble ou dispersable dans des milieux aqueux-alcalins ou des solvants organiques, au moins un composé organique, photopolymérisable, à bas poids moléculaire et à insaturation éthylénique, au moins un initiateur de photopolymérisation, ainsi qu'éventuellement d'autres additifs et/ou agents auxiliaires, caractérisé par le fait que l'on utilise, comme liant polymère, au moins un copolymérisat filmogène présentant une morphologie à plusieurs phases, une phase au moins ayant une température de transition vitreuse inférieure à la température ordinaire et une autre phase au moins une température de transition vitreuse supérieure à la température ordinaire, et ce copolymérisat a été obtenu par copolymérisation radicalaire d'au moins un macromère avec au moins un autre composé organique copolymérisable, à insaturation oléfinique, et, dans le copolymérisat présentant une morphologie à plusieurs phases, utilisé comme liant polymère, la phase continue présente une température de transition vitreuse inférieure à la température ordinaire et la phase dispersée une température de transition vitreuse supérieure à la température ordinaire.

2.  Matériau d'enregistrement sensible à la lumière, suivant la revendication 1, caractérisé par le fait que le liant polymère est un copolymérisat filmogène qui présente une morphologie à deux phases.

3.  Matériau d'enregistrement sensible à la lumière suivant l'une des revendications 1 ou 2, caractérisé par le fait que le liant polymère présente un poids moléculaire moyen (moyenne en poids) supérieur à 10 000.

4.  Matériau d'enregistrement sensible à la lumière, suivant l'une des revendications 1 à 3, caractérisé par le fait que le macromère utilisé pour la préparation du copolymérisat mis en oeuvre comme liant polymère, présente un poids moléculaire moyen (moyenne en poids) compris entre 1000 et 100 000.